# EUROPEAN PATENT APPLICATION

(11) **EP 1 568 949 A1**
(43) Date of publication of application: **31.08.2005**
(21) Application number: 03770061.4
(22) Date of filing: 30.10.2003
(51) Int. Cl.: F24H 3/04

(54) **GAS HEATING METHOD AND GAS HEATING DEVICE**

(30) Priority: 12.11.2002 JP 2002327706
(71) Applicant: Sumitomo Electric Industries, Ltd., Osaka 541-0041 (JP)
(72) Inventor: HASHIKURA, M.; c/o Itami Works, Itami-shi, Hyogo 664-0016 (JP); NAKATA, Hirohiko; c/o Itami Works, Itami-shi, Hyogo 664-0016 (JP)
(74) Representative: Cross, Rupert Edward Blount
(86) International application number: PCT/JP2003/013971
(87) International publication number: WO 2004/044500

(57) **Abstract**

Made available are a gas-heating method and a small-scale, energy-saving gas-heating device that, utilizing heaters that enable high-speed gas heat-up without being corroded by the gas, make possible the direct, efficient heating of gases.

A plurality of platelike ceramic heaters 30, or heater units in which a number of ceramic heaters are combined, is arranged in a staggered-ledge formation within a flow path or heating chamber for gases to create a zigzag gas flow-path *A*; gas supplied to the gas flow-path A is heated directly by the ceramic heaters 30 or heater units. This gas-heating device 10 can be utilized, in apparatuses that process NOₓ-containing exhaust gases or noxious/poisonous exhaust gases, for heating the exhaust gases and their diluent gases.

## Description

### Technical Field

The present invention relates to methods of heating gasses, and to gas-heating devices employed in various reaction apparatuses-for example, gas-heating devices employed in apparatuses that process NOₓ- or NH₃-containing exhaust gases discharged through semiconductor-device and liquid-crystal fabrication procedures, apparatuses that process noxious or poisonous exhaust gases from sterilizing and disinfecting procedures in hospitals, and other such apparatuses.

### Background Art

Semiconductor-device manufacturing procedures include wafer-processing stages in which semiconductor wafers are processed to create integrated circuits. Various processes such as thin-film deposition operations, oxidation operations, doping operations, and etching operations are carried out in the wafer-processing stages in order to form for example dielectric films, electrode wiring, and semiconductor films on the wafer front side.

In carrying out the various processes, techniques including physical vapor deposition, chemical vapor deposition, and epitaxial growth are employed, and because gases such as oxygen gas, hydrogen gas, and nitrous oxide gas are used in the processes, diverse spent gases and byproduct gases are generated as post-process exhaust gases. In particular, with operations in which a thermal oxide film is grown onto a wafer using a nitrous oxide gas, exhaust gas including nitrogen oxides (NOₓ) is produced. Likewise, in gallium-nitride epitaxial operations, exhaust gas including ammonia (NH₃) is produced.

Since discharging exhaust gases such as these to the exterior untreated can lead to environmental contamination, their concentration must be brought down to within permissible levels. For example, a known way of treating an exhaust gas that includes nitrogen oxides or NH₃ is the wet-absorption, or scrubber method, which passes the exhaust gas through a water shower to remove the nitrogen oxides or NH₃. Nevertheless, removing nitrogen oxides or NH₃ down to permissible levels using the scrubber method has presented difficulties.

As technology for processing NOₓ-containing exhaust gases discharged through semiconductor-device fabrication procedures, proposed in Japanese Unexamined Pat. App. Pub. No. H09-213596 are a processing method, and apparatus therefor, consisting of a step of mixing with a diluent gas exhaust gas including NOₓ generated through wafer-processing operations, a step of preheating the diluted exhaust gas, and an exclusion step of subjecting the exhaust gas to a selective catalytic reduction reaction to remove nitrogen oxides. Here, the selective catalytic reduction reaction reduces the NOₓ in an NOₓ-containing exhaust gas to nitrogen by adding a reducing gas such as ammonia to the exhaust gas and contacting the mixture with a catalyst made up of a metal composite of, for example, iron and manganese.

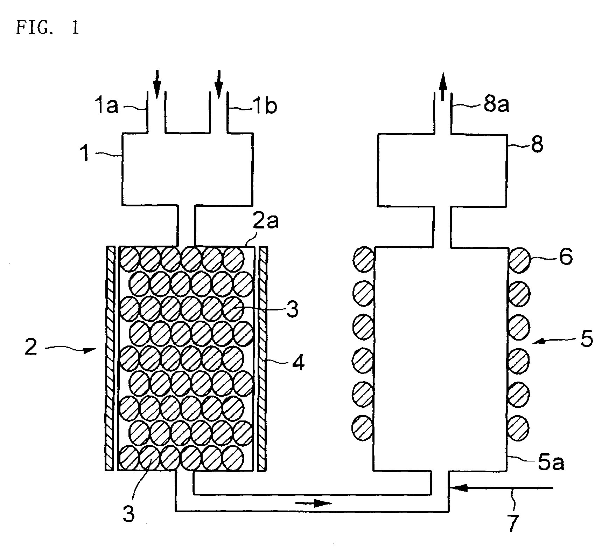

In turn, the apparatus for processing NOₓ-containing exhaust gases is furnished with, as shown in Fig. 1: a mixing section 1 having an exhaust-gas introduction port 1a and a diluent-gas introduction port 1b, and that mixes diluent gas-consisting of air or oxygen and an inert gas-into an exhaust gas; and an exhaust-gas preheating section 2 connected to the mixing section 1. The preheating section 2 has a tubular casing 2a filled with ceramic grains 3, and a tubular heater 4 provided on the outer side of the casing 2a, wherein the diluted exhaust gas is thus preheated.

The preheated exhaust gas flows into a reactor 5 from the preheating section 2, and at the same time a reducing gas such as NH₃ is added to it from a reducing-gas introduction line 7. A heater 6 in coiled form is provided on the outer side of a casing 5a for the reactor 5; while being maintained at a predetermined temperature, NOₓ-containing exhaust gas is brought into contact with a catalyst (not illustrated) inside the casing 5a, wherein NOₓ within the exhaust gas is thus reductively eliminated. After being cooled in a cooling section 8, exhaust gas from which NOₓ has been reductively eliminated in the reactor 5 is discharged to the exterior through an exhaust-gas outlet 8a.

Furthermore, in semiconductor fabrication processes perfluorocarbon (PFC) gas, which, being nontoxic to humans and non-explosive, is easy to handle, is being employed for the etching gas of dry etching and for the cleaning gas in CVD operations. The volume of gas actually consumed by etching or cleaning is several vol % to several dozen vol %, with the remainder being discharged to the reaction chamber exterior still unreacted.

The intermolecular bonding forces in PFCs, which are made up of non-chlorine-containing Freon™-FCs (fluorocarbons) and HFCs (hydrofluorocarbons)-and fluorinated compounds such as NF₃ and SF₆, are high; PFCs can therefore persist stably in the atmosphere for prolonged periods of time. For example, the lifespans of CF₄ at 50,000 years, of C₂F₆ at 10,000 years and of SF₆ at 3200 years are extremely long. By the same token, meanwhile, the global warming potential (GWP) of these gases is extremely large, with that of CF₄ being 6500 times that of CO₂, that of C₂F₆ being 9200 times, and that of SF₆ being 23,900 times.

Owing to recent regulations on toxic gas discharge, these gases are becoming regulatory targets. Accordingly, as one of the measures being taken to cope with emissions in semiconductor fabrication plants, the installation of apparatuses that process PFC gases by decomposition is underway. Chemical regimes and combustion regimes moreover have been made practicable as means for decomposing PFC gases. As an example of the latter, the combustion regimes, a method of decomposing such gases efficiently at a combustion temperature of 700°C using an alumina catalyst is proposed in Japanese Pat. Pub. No. 3,217,034. In this method, exhaust gas prior to entering a catalyst vessel is indirectly heated, by means of an electric heater within a heating device, to the approximately 650-750°C at which decomposition of PFCs begins.

Meanwhile, exhaust gases stemming from gases employed in sterilizing and disinfecting processes in institutions such as hospitals-gases such as ethylene oxide, propylene oxide, formaldehyde gas, and gaseous methyl radicals for example-are noxious or poisonous and therefore must be processed before being discharged to the exterior. Likewise, removal of poisonous gases such as carbon monoxide and gaseous hydrocarbons discharged in exhaust gas from for example combustion equipment and organic-solvent-based drying equipment is necessary before the exhaust gas is released into the atmosphere.

For apparatuses that process these sorts of noxious or poisonous exhaust gases, methods of processing the gases through decomposition by using an oxide catalyst to promote oxidation reaction of the gases are available, as set forth for example in Japanese Unexamined Pat. App. Pub. Nos. H09-290135 and 2000-325751. These methods allow the exhaust gases to be processed at lower, 200-400°C temperatures compared with burning off the gases directly.

In the apparatus described in Japanese Unexamined Pat. App. Pub. No. 2000-325751 for example, the flow volume of ethylene oxide gas is kept under constant control to stabilize the amount of heat emitted at the catalytic reaction temperature, and at the same time temperature conditions under which the catalytic effect is stable over the long term are sustained. In turn, the situation with the apparatus described Japanese Unexamined Pat. App. Pub. No. H09-290135 is that ethylene oxide gas, being poisonous, is delivered to a heater using a blowing means, and is purified by bringing the gas into contact with a catalyst after the gas is heated.

Nevertheless, there have been drawbacks with the conventional exhaust-gas processing apparatuses discussed above in that the heaters for heating the exhaust gases either heat the gas indirectly without being in contact with the gases, or else even if the heaters do contact the gases, because ordinary resistive heating elements are employed as the heaters, they are susceptible to being corroded by the gases; and on top of that, with it being impossible to heat the flowing gas efficiently the heating time is prolonged, which makes the power consumption considerable. Another problem has been that in order to heat the prescribed volumes of gas, the heating chambers must be made large, which has meant that the apparatuses are oversized.

### Disclosure of Invention

An object of the present invention, in view of such circumstances to date, is to make available a gas heating method, and a small-scale, energy-saving gas-heating device for implementing the heating method, that, utilizing heaters that enable high-speed gas heat-up without becoming corroded by the gas, make possible the direct, efficient heating of gases.

In order to achieve the foregoing objective, a gas heating method that the present invention affords is characterized in arranging within a gas flow path or heating chamber platelike ceramic heaters, or heater units in which a number of ceramic heaters are combined, and heating with the ceramic heaters or heater units gas supplied to the flow path or heating chamber. In particular, a plurality of the ceramic heaters or heater units is preferably arranged in a formation of staggered ledges to create a zigzag gas flow-path.

A gas-heating device that the present invention also affords is characterized in that within a gas flow path or heating chamber, platelike ceramic heaters, or heater units in which a number of ceramic heaters are combined, are arranged for coming into contact with gas. In particular, a plurality of the ceramic heaters or heater units is preferably set up in a formation of staggered ledges to create a zigzag gas flow-path.

In a specific use example in an exhaust-gas processing apparatus for the reductive elimination of nitrogen oxides or ammonia in exhaust gas from semiconductor fabrication procedures, the above-described gas-heating device of the present invention is utilized as a preheating unit that preheats the exhaust gas, or diluent gas that is mixed into the exhaust gas. Furthermore, in an exhaust-gas processing apparatus that breaks down and eliminates perfluorocarbons present in exhaust gas from semiconductor fabrication procedures, the gas-heating device of the invention is utilized as a heating unit that heats the exhaust gas, or diluent gas that is mixed into the exhaust gas. Further still, in an exhaust-gas processing apparatus for the oxidative decomposition of noxious or poisonous gases from sterilization and disinfecting procedures, the gas-heating device can be utilized as a heating unit that heats the exhaust gas, or diluent gas that is mixed into the exhaust gas.

The ceramic heaters in the foregoing gas-heating device of the present invention are characterized in being made up of a platelike ceramic substrate, and a heating element provided either on the surface of or inside the ceramic substrate. A preferable alternative is to constitute the ceramic heaters from a platelike ceramic substrate, a heating element being in a coiled pattern, provided on each of the two faces of the ceramic substrate, and a ceramic layer or a glass layer covering each of the two heating elements.

Furthermore, the ceramic substrate in the ceramic heaters described above is preferably made of aluminum oxide, silicon dioxide, aluminum nitride, silicon nitride, silicon carbide, zirconium boride, or a composite of these. Likewise, the heating elements in the ceramic heaters are preferably made of tungsten, molybdenum, a silver-palladium alloy, silver, or Nichrome™.

### Brief Description of Drawings

Fig. 1 is a schematic sectional view depicting a conventional apparatus for processing NOₓ-containing exhaust gases discharged through semiconductor-device fabrication procedures;
Fig. 2 is a schematic sectional view illustrating a specific example of a gas-heating device according to the present invention;
Fig. 3 is a schematic sectional view representing a specific example of a ceramic heater utilized in a gas-heating device of the present invention;
Fig. 4 is a schematic sectional view showing a specific example of a circuit pattern for a ceramic heater utilized in a gas-heating device of the present invention;
Fig. 5 is a schematic sectional view depicting a heater unit utilized in a gas-heating device of the present invention;
Fig. 6 is a schematic sectional view illustrating a specific example, in which a gas-heating device of the present invention is utilized, of an apparatus for processing NOₓ-containing exhaust gases discharged through semiconductor-device fabrication procedures; and
Fig. 7 is a schematic sectional view illustrating a specific example, in which a gas-heating device of the present invention is utilized, of an apparatus for processing poisonous gases discharged through sterilization/disinfection procedures.

### Best Mode for Carrying Out the Invention

In the present invention, platelike ceramic heaters, or heater units in which a number of ceramic heaters are combined, are arranged within a gas flow path or a gas heating chamber, and gas that flows in the flow path or heating chamber is directly heated by the ceramic heaters or the heater units. The gas can be efficiently heated in minimal space because it contacts the surface of the ceramic heaters or the heater units, or is heated by radiant heat at close range.

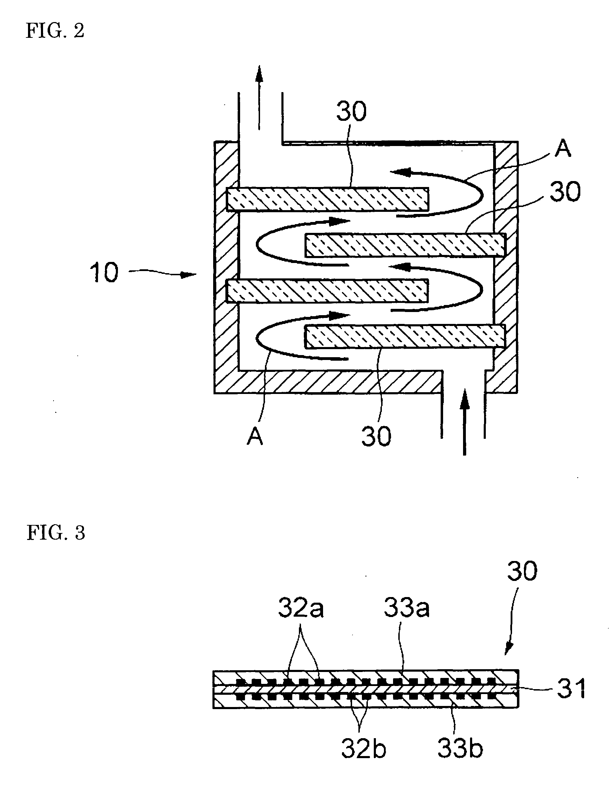

In order to implement the subject gas-heating method, as illustrated in Fig. 2 for example, a zigzag gas flow-path A is created by arranging a plurality of ceramic heaters 30 or heater units in a formation of staggered ledges in a gas-heating-device 10 gas-heating chamber in which gas flows. Adopting a configuration of this sort increases the surface area in which the gas contacts the ceramic heaters 30 or the heater units, improving the efficiency with which heat is transferred to the flowing gas and making it possible to scale down the heating chamber. It will be appreciated that the form of the gas flow path A can be freely altered by varying the mounting locations of the ceramic heaters 30 or heating units.

The ceramic heaters utilized as a heat source are made up of a platelike ceramic substrate, and a heating element provided either on the front side of or inside the ceramic substrate, and allow Joule heat generated in the heating element by passing an electric current through it to be transmitted to the gas via the ceramic, which is of high thermal conductivity; moreover, the thinner the overall thicknesses are made, the more the heaters are capable of high-speed heat-up and rapid cool-down. The stand-by time that it takes for the heaters to heat up can accordingly be shortened, which curtails the time during which current is drawn and thus contributes to reducing power consumption.

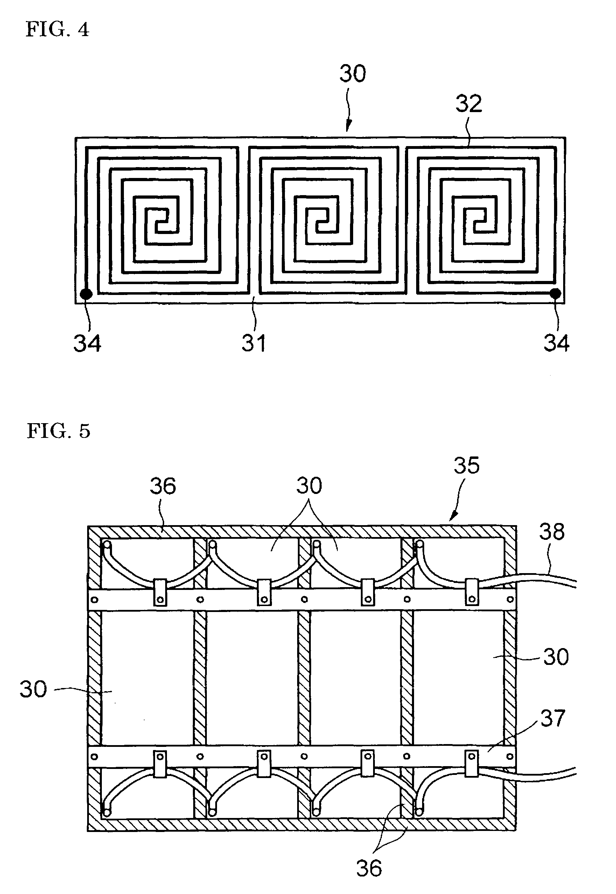

A ceramic heater of the configuration illustrated in Figs. 3 and 4 is especially preferable as an example involving the present invention. Such a heater is furnished with a thin platelike ceramic substrate 31 of superior heat conductance and resistance to heat and corrosion, and heating elements 32 (32a, 32b) formed in coil patterns on each of the two faces of the ceramic substrate 31. The heating elements 32 (32a, 32b) are each coated with a layer 33a, 33b of either ceramic or glass. Also, at reference numerals 34, 34 in Fig. 4 are electrodes for passing current to the heating element 32.

The layers 33a, 33b of either ceramic or glass that cover the heating elements 32a, 32b preferably are of the same type of ceramic as the ceramic substrate 31, or else are of glass whose difference with the ceramic substrate 31 in thermal expansion coefficient is minimal, in order to prevent breakage and to keep the layers from peeling off. In this way covering the heating elements 32a, 32b with a layer 33a, 33b of either ceramic or glass that is resistant to corrosion also contributes to preventing corrosion of the heating elements 32a, 32b.

The pattern of the heating element 32 circuit is, as shown in Fig. 4, rendered in the form of a single coil, or as a combination of more than one coil patterns. Rendering the pattern in a coil form raises the density of the heating elements 32 and makes them more uniform, which therefore makes the heating all the more efficient and enables rapid heating and rapid cooling, and at the same time makes the temperature distribution in the heater surface uniform and contributes to reducing fluctuations in the gas temperature.

As stated earlier, instead of the ceramic heaters, heating units in which a number of ceramic heaters are combined can be utilized. An example would be a heater package 35 as illustrated in Fig. 5, in which four ceramic heaters 30 are arranged in parallel in a row and mounted in a frame 36 into which the heaters are fixed with support members 37. In this case, at reference numeral 38 in Fig. 5 is a lead line for passing current to each ceramic heater 30. The support members 37 may be of a substance that is an insulator, but making them an electroconductive substance allows them to be used as lead lines so that the lead lines 38 can be omitted. Then for the substance of the frame 36, a metal such as SUS steel, or an insulator such as glass or a synthetic resin can be utilized. Through a heating unit of this kind a heat source having a large surface area with which gas comes into contact may be accomplished, which is therefore advantageous in situations in which the cubic capacity of the heating chamber is large, or in situations in which the gas flow speed is fast. Moreover, even in situations apart from these, in order to enlarge the area with which gas comes into contact the heater unit may be made three-dimensional by rearranging the way in which the ceramic heaters 30 are mounted.

A method of manufacturing the ceramic heaters described above renders the heating elements by forming heater circuits onto both faces of a thin ceramic substrate using a technique such as printing, and then firing the circuits onto the substrate. Next, a layer of either ceramic or glass is formed so as to cover the heating elements. Here, in the case in which the heating elements on the ceramic substrate are to be covered with a ceramic layer, the heater circuits can be formed in between ceramic green sheets and the ceramic substrate, and the substrate and green sheets can then be baked to bond the ceramic layers onto the substrate at the same time the heating elements are fired onto it.

Aluminum oxide, silicon dioxide, aluminum nitride, silicon nitride, silicon carbide, zirconium boride, or a composite of these is preferable as the ceramic substrate in the ceramic heaters. It should be understood that among the ceramics just enumerated, silicon carbide, zirconium boride, or a composite thereof can, by passing current directly into them, be heated without being formed with heating elements.

Again, the heating elements are preferably made of tungsten, molybdenum, a silver-palladium alloy, silver, or Nichrome™. A ceramic layer covering the heating elements preferably is of a ceramic that is the same type as the ceramic substrate. For a glass layer covering the heating elements, glass whose difference with the ceramic substrate in coefficient of thermal expansion is minimal-a ZnO-B₂O₃-SiO₂ system glass for example-is preferable.

As to examples of how the above-described gas-heating device of the present invention may be used, in for instance an exhaust-gas processing apparatus for the reductive elimination of nitrogen oxides (NOₓ) or NH₃ in exhaust gas discharged through semiconductor fabrication procedures, the inventive gas-heating device can be utilized as a preheating unit that preheats the NOₓ- or NH₃-containing exhaust gas, or diluent gas that is mixed into the exhaust gas. Furthermore, in an exhaust-gas processing apparatus that breaks down and eliminates perfluorocarbons present in exhaust gas from semiconductor fabrication procedures, the inventive gas-heating device can be utilized as a heating unit that heats the exhaust gas, or diluent gas that is mixed into the exhaust gas. Further still, in an exhaust-gas processing apparatus for the oxidative decomposition of poisonous or noxious gases discharged through sterilization and disinfecting procedures in institutions such as hospitals, the inventive gas-heating device can be utilized as a heating unit that heats the exhaust gas, or diluent gas that is mixed into the exhaust gas.

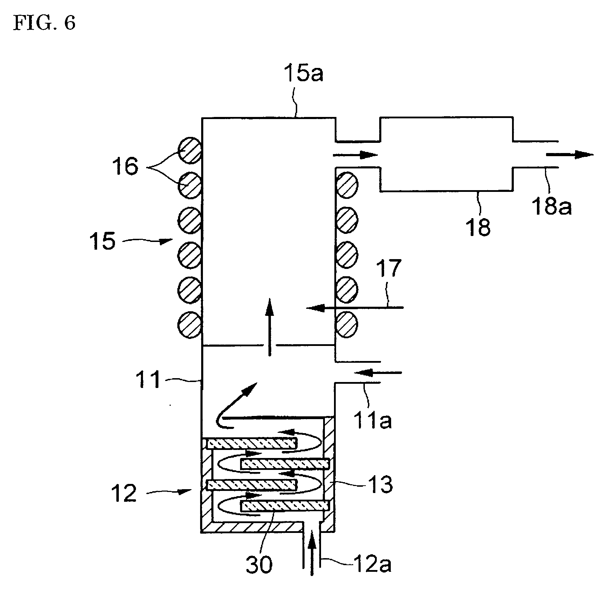

A specific example in which a gas-heating device of the present invention is for instance utilized for the preheating unit in an apparatus for processing NOₓ-containing exhaust gas, which by a catalytic reducing reaction breaks down and eliminates nitrogen oxides included in exhaust gas from semiconductor fabrication procedures, is illustrated in Fig. 6. The apparatus for processing NOₓ-containing exhaust gas is equipped with: a preheating unit 12 for preheating air or a like diluent gas supplied through a diluent-gas introduction port 12a; a mixing section 11 that mixes into the preheated diluent gas NOₓ-containing exhaust gas introduced through an exhaust-gas introduction port 11a; and a reactor 15 in which by contacting the diluted exhaust gas with a (not illustrated) catalyst, the nitrogen oxides (NOₓ) are reductively eliminated by selective catalytic reduction.

Inside a casing 13 for the preheating unit 12, a plurality of ceramic heaters 30 or heater units is arranged in a formation of staggered ledges to create a zigzag gas flow path. Accordingly, while air, being the diluent gas taken in through the diluent-gas introduction port 12a, flows weaving its way through the zigzag gas flow path formed with the ceramic heaters 30 or heater units, it is preheated to a temperature at about the 380-400°C level by the ceramic heaters 30 or heater units.

In the mixing section 11, the preheated air is mixed with the NOₓ-containing exhaust gas supplied through the exhaust-gas introduction port 11a, and in the reactor 15, a reducing gas such as NH₃, supplied through a reducing-gas introduction line 17, is added to the preheated air. The reactor 15 is filled with a catalyst (not illustrated) consisting, for example, of a composite of metals such as iron and manganese, and a heater 16 in coiled form is provided on the outside of the reactor casing 15a. Therein, while the coiled heater 16 maintains the temperature inside the reactor 15 at about the 180-250°C level, on the catalyst the NOₓ in the exhaust gas is reacted with the added NH₃ and is thus reductively eliminated. Meanwhile, excess added NH₃, reacting on the catalyst with O₂ in the air, is eliminated as N₂ and H₂O. Exhaust gas from which NOₓ has been reductively eliminated in the NH₃ reactor 15 is cooled to a temperature of about 80°C or lower in a cooling unit 18 and subsequently is discharged to the exterior through an exhaust-gas outlet 18.

It will be appreciated that the above-described gas-heating device can be utilized in nearly the same way also as an exhaust-gas heating unit in an apparatus for processing exhaust gas in which NOₓ, NH₃, or perfluorocarbons present in exhaust gas from semiconductor fabrication procedures is broken down and eliminated.

In conventional apparatuses for processing NOₓ-containing exhaust gas, as represented in Fig. 1, the diluent-and-exhaust gas mixing section 1, the mixed gas preheating section 2, and the reactor 5 for reductive elimination of nitrogen oxides using a catalyst have been laid out separately, wherein the preheating section 2 has been large and its heating efficiency extraordinarily poor. In contrast, with the present invention, utilizing the ceramic heaters 30 or the heater units as a heat source allows the diluent gas to be preheated highly efficiently and makes it possible moreover to scale down the preheating unit 12; consequently the preheating unit 12 can be made unitary with the mixing section 11 and the reactor 15.

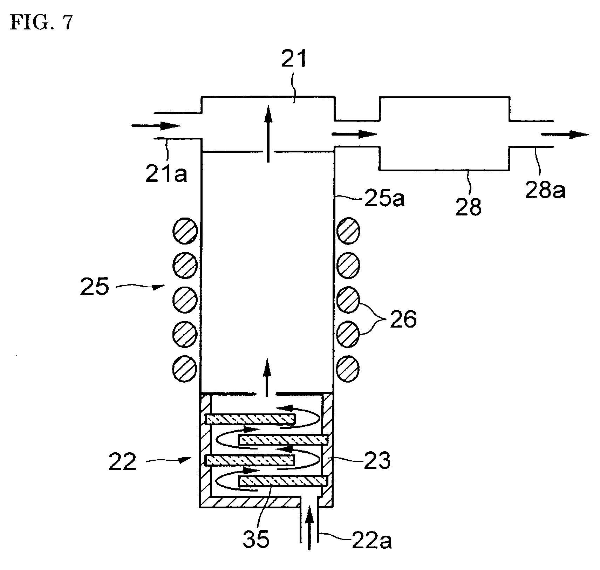

Turning now to a specific example in which a gas-heating device of the present invention is utilized for the heating unit in an exhaust-gas processing apparatus for the oxidative decomposition of poisonous or noxious exhaust gases from sterilization and disinfecting procedures in institutions such as hospitals, reference is made to the illustration in Fig. 7. The exhaust-gas processing apparatus in Fig. 7 is equipped with: a heating unit 22 for heating noxious exhaust gas employed in sterilization/disinfecting procedures, the gas being supplied through a noxious-gas introduction port 22a; a reactor 25 in which the heated noxious gas is oxidatively decomposed by being brought into contact with a catalyst (not illustrated); a mixing section 21 that mixes into the oxidatively decomposed gas air or a like diluent gas introduced through a diluent-gas introduction port 21a; and a cooling section 28 that cools the diluted mixture and discharges it to the exterior through an exhaust-gas outlet 28a.

In this apparatus for processing noxious gas the configuration of the heating unit 22 is nearly the same as that of the preheating unit 12 illustrated n Fig. 6: A plurality of platelike ceramic heaters or heater packages 35 is arranged in a formation of staggered ledges within a casing 23. More specifically, as depicted in Fig. 7 heater packages 35 in which a number of platelike ceramic heaters are combined are arranged in split levels-each in alternation cantilevered at one end from the inner walls of the casing 23 so that extending out from the inner walls of the casing 23 their other ends overlap-to create a zigzag gas flow path within the casing 23.

While the noxious gas flows weaving its way through the zigzag gas flow path formed by the ceramic heaters or the heater packages 35, it is heated to a temperature at about the 400-600°C level. Here, the configuration of the reactor 25 is the same as that in Fig. 6: The interior of the reactor casing 25a is filled with an oxidizing catalyst (not illustrated), and a coiled heater 26 is provided on the outside of the casing 25a. Likewise, a configuration similar to that of the Fig. 6 apparatus, in which the noxious gas is mixed with the diluent gas and then is supplied to the reactor and subjected to an oxidative decomposition reaction, can be adopted in the noxious-gas processing apparatus of Fig. 7.

In the present invention, thus utilizing ceramic heaters as a heat source for heating gases allows Joule heat generated in the heating element to be efficiently transmitted to a gas through the ceramic-which is of high thermal conductivity-and the ceramic or glass layers; moreover, the thinner the ceramic-heaters are made, the more they are capable of rapid heat-up and rapid cool-down. The stand-by time that it takes for the heaters to heat up can accordingly be shortened, which curtails the time during which current is drawn and thus contributes to reducing power consumption.

In addition, with regard to, other than exhaust-gas processing apparatuses, reaction apparatuses that utilize a gas-heating device according to the present invention, the fact that utilizing ceramic heaters as a gas-heating heat source allows the gas flow-path and heating chamber in the gas-heating device to be scaled down enables designing apparatuses-in which the structure is made unitary for example-that are scaled-down as a whole.

### Embodiment

A gas-heating device according to the present invention was applied to an apparatus for processing noxious exhaust gases, employed in sterilization and disinfecting procedures in hospitals. In particular, as illustrated in Fig. 7, four heater packages 35 in each of which four ceramic heaters were combined were arranged within the casing 23 in a formation of staggered ledges to create within the casing 23 a zigzag gas flow path as a heating unit 22 for heating noxious exhaust gas supplied through the noxious-gas introduction port 22a.

In specific terms, the heating unit 22 was furnished with a casing 23 of SUS steel, the interior of which was 430 mm × 430 mm × 480 mm height, and four platelike heater packages 35, each 420 mm × 300 mm × 5 mm thickness, were arranged inside the casing 23 so as to define a formation of staggered ledges spaced apart from each other by 90 mm. Here, the structure of each heater package 35 was one in which, as shown in Fig. 5, four ceramic heaters 30 were assembled into a flat planar form and fixed using a frame 36 and support members 37. In this case, glass was used for the frame 36.

The ceramic heaters 30 configuring each heater package 35 were of a structure in which, as shown in Fig. 3, on the two faces of a ceramic substrate 31 made of platelike AlN 0.6 mm in thickness, heating elements 32a, 32b of Pd-Ag were formed, onto which respective glass layers 33a, 33b were coated, with the overall heater thickness being 0.605 mm. Here, as shown in Fig. 4, the heating elements 32a, 32b were patterned as a linked series of three spiral-shaped circuits, with electrodes 34, 34 being furnished at either end of the pattern for passing current into the circuits.

While ethylene oxide gas was introduced continuously into the heating unit 22 through the noxious-gas introduction port 22a at 2000 liters/minute, 7 kW electric power was passed into the heater packages 35. As a result, the heater packages 35 reached a maximum temperature of 400°C in approximately 500 seconds, which allowed the gas temperature in the proximity of the heater unit 22 outlet to be heated to approximately 350°C. The heated ethylene oxide gas was introduced into the reactor 25 and contacted with an oxidizing catalyst at a temperature of approximately 400°C; the oxidative decomposition product from the reactor 25 was diluted by mixing it with air in the mixing section 21, then was cooled in and discharged from the cooling section 28. Almost no ethylene oxide was contained in the gas discharged from the gas-discharge port 28a.

### Industrial Applicability

The present invention makes available a gas-heating method and a gas-heating device therefor that, by utilizing heaters that enable high-speed gas heat-up without undergoing corrosion from the gas, allow the gas to be heated directly and efficiently. In turn, because the gas-heating device manages while being small-scale and energy-saving, utilizing the gas-heating device in various exhaust-gas processing apparatuses as a preheating or heating unit for the exhaust gases, or for diluent gases into which the exhaust gases are mixed, enables the apparatuses in their entirety to be designed scaled-down and energy-saving.

## Claims

1. A gas heating method, **characterized in** arranging within a gas flow path or heating chamber platelike ceramic heaters, or heater units in which a number of ceramic heaters are combined, and heating with the ceramic heaters or heater units gas supplied to the flow path or heating chamber.

2. A gas heating method as set forth in claim 1, **characterized in that** a plurality of the ceramic heaters or heater units is arranged in a formation of staggered ledges to create a zigzag gas flow-path.

3. A gas heating device, **characterized in that** within a gas flow path or heating chamber, platelike ceramic heaters, or heater units in which a number of ceramic heaters are combined, are arranged for coming into contact with gas.

4. A gas-heating device as set forth in claim 3, **characterized in that** a plurality of said ceramic heaters or heater units is set up in a formation of staggered ledges to create a zigzag gas flow-path.

5. A gas-heating device as set forth in claim 3 or 4, **characterized in** being utilized in an exhaust-gas processing apparatus for the reductive elimination of nitrogen oxides or ammonia in exhaust gas from semiconductor fabrication procedures, as a preheating unit for preheating the exhaust gas, or diluent gas that is mixed into the exhaust gas.

6. A gas-heating device as set forth in claim 3 or 4, **characterized in** being utilized in an exhaust-gas processing apparatus for breaking down and eliminating perfluorocarbons present in exhaust gas from semiconductor fabrication procedures, as a heating unit for heating the exhaust gas, or diluent gas that is mixed into the exhaust gas.

7. A gas-heating device as set forth in claim 3 or 4, **characterized in** being utilized in an exhaust-gas processing apparatus for the oxidative decomposition of noxious or poisonous gases from sterilization and disinfecting procedures, as a heating unit for heating the exhaust gas, or diluent gas that is mixed into the exhaust gas.

8. A gas-heating device as set forth in any of claims 3 through 7, **characterized in that** said ceramic heaters are made up of a platelike ceramic substrate, and a heating element provided either on the surface of or inside the ceramic substrate.

9. A gas-heating device as set forth in any of claims 3 through 8, **characterized in that** said ceramic heaters are constituted from a platelike ceramic substrate, a heating element being in a coiled pattern, provided on each of the two faces of the ceramic substrate, and a ceramic layer or a glass layer covering each of the two heating elements.

10. A gas-heating device as set forth in any of claims 3 through 9, **characterized in that** the ceramic substrate in said ceramic heaters is made of aluminum oxide, silicon dioxide, aluminum nitride, silicon nitride, silicon carbide, zirconium boride, or a composite of these.

11. A gas-heating device as set forth in any of claims 3 through 10, **characterized in that** the heating elements in said ceramic heaters are made of tungsten, molybdenum, a silver-palladium alloy, silver, or Nichrome™.
